# EUROPÄISCHE PATENTANMELDUNG

(11) **EP 1 545 180 A2**
(43) Veröffentlichungstag der Anmeldung: **22.06.2005**
(21) Anmeldenummer: 04027142.1
(22) Anmeldetag: 15.11.2004
(51) Int. Cl.: H05K 7/20

(54) **Wärmeleitende Einlegematte für elektrische und elektronische Geräte und Verfahren zur Herstellung derartiger Einlegematten**

(30) Priorität: 16.12.2003 DE 10359157
(71) Anmelder: Patent-Treuhand-Gesellschaft für Elektrische Glühlampen mbH, 81543 München (DE)
(72) Erfinder: Haeusser-Boehm, Helmut, Dr., 81547 München (DE)

(57) **Zusammenfassung**

Die Erfindung betrifft eine wärmeleitende Einlegematte (1) für elektrische und elektronische Geräte und ein Herstellungsverfahren für derartige Einlegematten (1) sowie ein Betriebsgerät mit derartiger Einlegematten. Erfindungsgemäß ist die Einlegematte (1) als Kunststoff-Strangpress-Profil ausgebildet.

## Beschreibung

Die Erfindung betrifft ein Verfahren zur Herstellung wärmeleitender Einlegematten für elektrische und elektronische Geräte gemäß des Oberbegriffs des Patentanspruchs 1 und wärmeleitende Einlegematten gemäß des Oberbegriffs des Patentanspruchs 3 sowie Betriebsgeräte für elektrische Lampen mit derartigen Einlegematten.

### I. Stand der Technik

Die Offenlegungsschrift EP 0 986 292 A2 offenbart eine wärmeleitende Einlegematte für elektrische und elektronische Geräte, die aus einem modifizierten Kohlenwasserstoffharz oder aus einer Silikonverbundfolie besteht. Diese Einlegematten sind verformbar, biegsam und weisen eine weiche sowie klebrige Konsistenz auf. Die Einlegematten werden aus einer Vergussmasse hergestellt, die in Formen gegossen wird und anschließend unter Vakuum und Zufuhr von Wärme ungefähr acht Stunden ausgehärtet wird. Die Kosten dieser Einlegematten sind aufgrund des zeitaufwändigen Herstellungsverfahrens und der großen Anzahl der benötigten Gussformen für die Einlegematten unterschiedlicher Abmessungen hoch.

### II. Darstellung der Erfindung

Es ist die Aufgabe der Erfindung, ein vereinfachtes Verfahren zur Herstellung wärmeleitender Einlegematten für elektrische und elektronische Geräte sowie derartige Einlegematten bereitzustellen.

Diese Aufgabe wird erfindungsgemäß durch die Merkmale des Patentanspruchs 1 bzw. 3 gelöst. Besonders vorteilhafte Ausführungen der Erfindung sind in den abhängigen Patentansprüchen beschrieben.

Erfindungsgemäß werden die wärmeleitenden Einlegematten für elektrische und elektronische Geräte aus einem elektrisch isolierenden, wärmeleitenden Kunststoff durch Strangpressen mittels eines Extruders hergestellt. Dieses Verfahren erlaubt im Gegensatz zum Herstellungsverfahren gemäß des Standes der Technik eine kostengünstige Massenfertigung der Einlegematten. Die Form der Einlegematten ist durch die Gestalt der Austrittsdüsenöffnung des Extruders bestimmt und kann daher ohne großen Aufwand an die gewünschte Anwendung angepasst werden. Insbesondere werden keine Gussformen mehr benötigt wie beim Herstellungsverfahren gemäß des Standes der Technik. Zur Herstellung der wärmeleitenden Einlegematten können alle thermoplastischen, wärmeleitenden Kunststoffe verwendet werden. Besonders vorteilhaft sind allerdings solche Kunststoffe, die neben einer hohen Wärmeleitfähigkeit auch eine gute elektrische Isolierung ermöglichen. Die Einlegematten gemäß des bevorzugten Ausführungsbeispiel bestehen daher aus Silikon.

Entsprechend dem erfindungsgemäßen Herstellungsverfahren sind die erfindungsgemäßen wärmeleitenden Einlegematten als Kunststoff-Strangpress-Profil ausgebildet. Die erfindungsgemäßen Einlegematten weisen vorteilhaft eine ebene Unterseite und eine mit Längsrinnen versehene Oberseite auf. Die ebene Unterseite erlaubt eine gute thermische Kopplung zu einer Gehäusewand eines elektrischen Gerätes, während die Lamellen auf der Oberseite, welche die Längsrinnen begrenzen, unterschiedliche Abstände zwischen der Gehäusewand und der Wärmequelle ausgleichen können, da die Lamellen flexibel und biegsam sind. Die Lamellen können hohl ausgebildet sein, um die Flexibilität zu erhöhen.

Ein bevorzugtes Anwendungsgebiet für die erfindungsgemäßen wärmeleitenden Einlegematten sind Betriebsgräte für elektrische Lampen. Diese Betriebsgerät besitzen üblicherweise ein Gehäuse und innerhalb des Gehäuses angeordnete elektronische Bauteile zum Betrieb von Lampen. Um die von den elektronischen Bauteilen generierte Wärme über das Gehäuse besser abführen zu können, ist zwischen den elektronischen Bauteilen und dem Gehäuse mindestens eine der erfindungsgemäßen Einlegematten angeordnet. Die elektronischen Bauteile des Betriebsgerätes sind vorzugsweise auf einer Montageplatine fixiert, die mit geringem Abstand zu einer Gehäusewand, beispielsweise zum Boden des Betriebsgerätes angeordnet ist. Eine erfindungsgemäße Einlegematte ist vorteilhaft zwischen der Montageplatine und der vorgenannten Gehäusewand des Betriebsgerätes angeordnet, um eine gute thermische Kopplung zwischen den elektronischen Bauteilen und dieser Gehäusewand zu erhalten. Zur weiteren Verbesserung der Wärmeabfuhr kann die mittels der Einlegematte thermisch an die Montagplatine gekoppelte Gehäusewand als Wärmesenke ausgebildet sein, indem sie beispielsweise aus einem Metallblech besteht oder mit einem Metallblech versehen ist.

### III. Beschreibung der bevorzugten Ausführungsbeispiele

Nachstehend wird die Erfindung anhand bevorzugter Ausführungsbeispiele näher erläutert. Es zeigen:
- Figur 1: Eine Seitenansicht eines ersten Ausführungsbeispiels der erfindungsgemäßen Einlegematte
- Figur 2: Eine Seitenansicht eines zweiten Ausführungsbeispiels der erfindungsgemäßen Einlegematte
- Figur 3: Eine Seitenansicht eines dritten Ausführungsbeispiels der erfindungsgemäßen Einlegematte
- Figur 4: Einen Querschnitt durch ein Betriebsgerät für elektrische Lampen

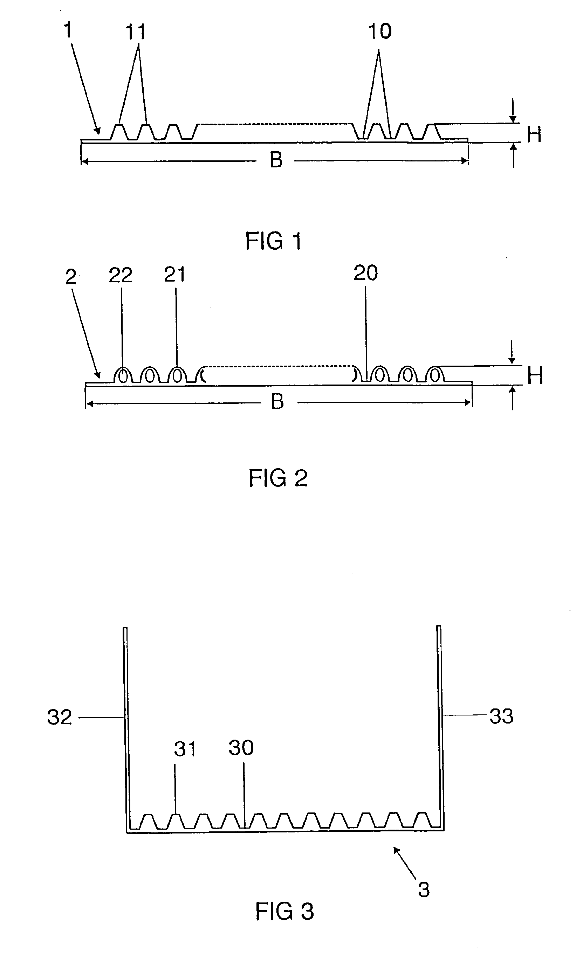

In der Figur 1 ist ein erstes Ausführungsbeispiel der erfindungsgemäßen Einlegematte schematisch dargestellt. Diese Einlegematte 1 besteht aus Silikon und besitzt eine Breite B von 80 mm sowie eine Dicke H von 5 mm. Die Unterseite der Einlegematte 1 ist eben ausgebildet, während ihre Oberseite mit einer Vielzahl von Längsrinnen 10 versehen ist, die eine Tiefe von 4 mm aufweisen. Die Längsrinnen 10 werden seitlich von Lamellen 11 begrenzt. Die Einlegematte 1 ist flexibel und biegsam.

Die Figur 2 zeigt ein zweites Ausführungsbeispiel der erfindungsgemäßen Einlegematte in schematischer Darstellung. Diese Einlegematte 2 besteht aus Silikon und besitzt eine Breite B von 80 mm sowie eine Dicke H von 5 mm. Die Unterseite der Einlegematte 2 ist eben ausgebildet, während ihre Oberseite mit einer Vielzahl von Längsrinnen 20 versehen ist, die eine Tiefe von 4 mm aufweisen. Die Längsrinnen 20 werden seitlich von hohlen Lamellen 21 begrenzt. Die Einlegematte 2 ist flexibel und biegsam.

In der Figur 3 ist ein drittes Ausführungsbeispiel der erfindungsgemäßen Einlegematte schematisch dargestellt. Diese Einlegematte 3 besteht ebenfalls aus Silikon. Die Unterseite der Einlegematte 3 ist eben ausgebildet, während ihre Oberseite mit einer Vielzahl von Längsrinnen 30 versehen ist, die eine Tiefe von 4 mm aufweisen. Die Längsrinnen 30 werden seitlich von Lamellen 31 begrenzt. Die Dicke der Einlegematte 3 beträgt 5 mm. An ihren beiden Seitenkanten weist die Einlegematte 3 jeweils eine in Längsrichtung verlaufende, angeformte Seitenwand 32 bzw. 33 auf. Die Einlegematte 3 ist flexibel und biegsam. Diese Einlegematte 3 ermöglicht eine thermische Kopplung an den Boden und zwei Seitenwänden des Gehäuses eines elektrischen Gerätes sowie auch eine elektrische Isolierung der Bauelemente.

Zur Herstellung der oben beschriebenen Einlegematten wird Silikon, beispielsweise in Form von Pulver oder Granulat, in einen Extruder gefüllt und unter Wärmezufuhr mittels einer Schnecke homogenisiert und dabei zur formgebenden Düse im Spritzkopf des Extruders transportiert. Das Extrudieren bzw. Strangpressen an sich ist ein bekanntes Verfahren und soll daher hier nicht näher erläutert werden. Die Gestalt der Düsenöffnung im Spritzkopf entspricht jeweils den in den Figuren 1 bis 3 abgebildeten Profilen der Einlegematten.

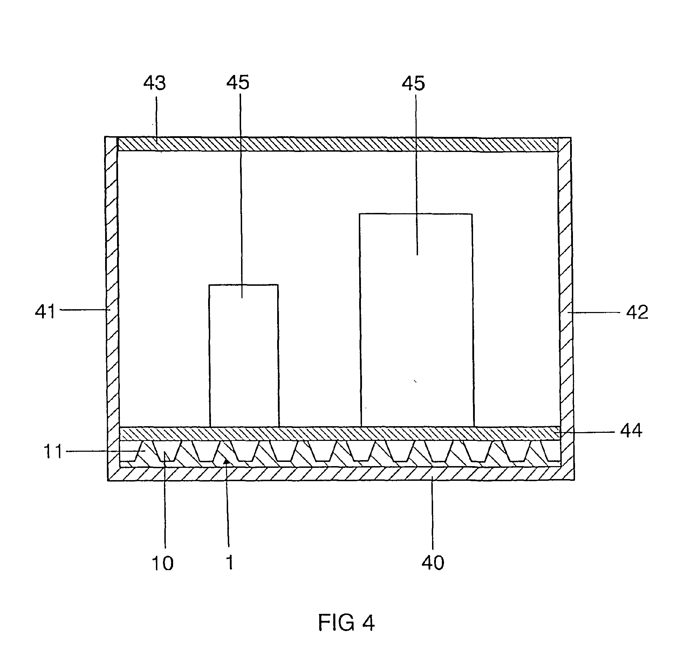

In der Figur 4 ist ein Querschnitt durch ein Betriebsgerät für elektrische Lampen schematisch dargestellt. Das Betriebsgerät besitzt ein im wesentlichen quaderförmiges Gehäuse mit einem Boden 40, zwei Seitenwänden 41, 42, einer Abdeckung 43 und zwei stirnseitigen Seitenwänden (nicht abgebildet). Innerhalb des Gehäuses sind auf einer Montageplatine 44 fixierte, elektronische Bauteile 45 angeordnet, die zum Betrieb einer oder mehrerer elektrischer Lampen dienen. Die Montageplatine 44 ist in einem Abstand von ungefähr 5 mm oberhalb des Bodens 40 angeordnet. Im Zwischenraum zwischen dem Boden 40 und der Montageplatine 44 befindet sich die in Figur 1 abgebildet Einlegematte 1. Die ebene Unterseite der Einlegematte 1 liegt auf dem Boden 40 auf, während die mit den Längsrinnen 10 bzw. Lamellen 11 versehene Oberseite sich im Kontakt mit der Montageplatine befindet.

## Patentansprüche

1. Verfahren zur Herstellung einer wärmeleitenden Einlegematte, **dadurch gekennzeichnet, dass** die Einlegematte (1) aus einem wärmeleitenden Kunststoff durch Strangpressen mittels eines Extruders hergestellt wird.

2. Verfahren nach Anspruch 1, **dadurch gekennzeichnet, dass** der wärmeleitende Kunststoff Silikon ist.

3. Wärmeleitende Einlegematte für elektrische oder elektronische Geräte, **dadurch gekennzeichnet, dass** die Einlegematte (1) als Kunststoff-Strangpress-Profil ausgebildet ist.

4. Einlegematte nach Anspruch 3, **dadurch gekennzeichnet, dass** die Einlegematte (1) aus einem elektrisch isolierenden Kunststoff besteht.

5. Einlegematte nach Anspruch 3, **dadurch gekennzeichnet, dass** die Einlegematte (1) eine ebene Unterseite und eine mit Längsrinnen (10) versehene Oberseite besitzt.

6. Einlegematte nach Anspruch 5, **dadurch gekennzeichnet, dass** die die Längsrinnen (10) begrenzenden Lamellen (11) hohl sind.

7. Betriebsgerät für elektrische Lampen mit einem Gehäuse, innerhalb des Gehäuses (40, 41, 42, 43) angeordneten elektronischen Bauteilen (45) und mindestens einer zwischen den elektronischen Bauteilen (45) und dem Gehäuse (40, 41, 42, 43) angeordneten Einlegematte (1) gemäß eines oder mehrerer der vorstehenden Ansprüche.
